# EUROPEAN PATENT APPLICATION

(11) **EP 4 750 250 A2**
(43) Date of publication of application: **27.05.2026**
(21) Application number: 25206370.6
(22) Date of filing: 02.10.2025
(51) Int. Cl.: H10D 30/01, H10D 30/47, H10D 30/67, H10D 30/00

(54) **SEMICONDUCTOR DEVICE INCLUDING TWO-DIMENSIONAL NANO-CRYSTALLINE GRAIN CHANNEL, METHOD OF MANUFACTURING SEMICONDUCTOR DEVICE, AND ELECTRONIC APPARATUS INCLUDING SEMICONDUCTOR DEVICE**

(30) Priority: 21.11.2024 KR 20240167757
(71) Applicant: Samsung Electronics Co., Ltd., Suwon-si, Gyeonggi-do 16677 (KR)
(72) Inventor: Yoo, Minseok, 16678 Suwon-si, Gyeonggi-do (KR); Seol, Minsu, 16678 Suwon-si, Gyeonggi-do (KR); Jung, Alum, 16678 Suwon-si, Gyeonggi-do (KR)
(74) Representative: Grünecker Patent- und Rechtsanwälte PartG mbB

(57) **Abstract**

Provided are a semiconductor device including a two-dimensional nano-crystalline grain channel, a method of manufacturing the semiconductor device, and an electronic apparatus including the semiconductor device. The semiconductor device includes a channel layer, a gate electrode disposed to face the channel layer, a gate insulating film disposed between the channel layer and the gate electrode, and a source electrode and a drain electrode electrically connected to the channel layer. The channel layer includes a first transition metal dichalcogenide layer and a second transition metal dichalcogenide layer disposed on the first transition metal dichalcogenide layer. The first transition metal dichalcogenide layer includes a highly crystalline transition metal dichalcogenide material having a two-dimensional crystal structure. The second transition metal dichalcogenide layer includes a nano-crystalline grain transition metal dichalcogenide material having a two-dimensional crystal structure.

## Description

### BACKGROUND

### 1. Field

The disclosure relates to a semiconductor device including a two-dimensional nano-crystalline grain channel, a method of manufacturing the semiconductor device, and an electronic apparatus including the semiconductor device.

### 2. Description of the Related Art

Field effect transistors (FET) are semiconductor devices that are configured to perform an electrical switching role and are used in various integrated circuit (IC) devices including memories, driving ICs, logic devices, and the like. With the increase in a demand for a higher degree of integration of IC devices, the available space occupied by the transistors provided therein has also rapidly reduced. Accordingly, attempts have been made to form transistors using two-dimensional materials instead of silicon-based three-dimensional bulk materials. However, two-dimensional materials are easily peeled off in a device manufacturing process. In addition, it is difficult to uniformly deposit an insulator on a two-dimensional material.

### SUMMARY

The invention is claimed in the independent claims. Preferred embodiments are specified in the dependent claims.

Provided are a semiconductor device, in which a two-dimensional nano-crystalline grain material that is not easily peeled off in a manufacturing process is used as a channel, and an electronic apparatus including the semiconductor device.

Provided is a method of manufacturing the semiconductor device.

Additional aspects will be set forth in part in the description which follows and, in part, will be apparent from the description, or may be learned by practice of the presented embodiments of the disclosure.

According to an aspect of the disclosure, a semiconductor device includes a channel layer comprising a first transition metal dichalcogenide layer and a second transition metal dichalcogenide layer on the first transition metal dichalcogenide layer, a gate electrode facing the channel layer, a gate insulating film between the channel layer and the gate electrode, and a source electrode and a drain electrode electrically connected to the channel layer, wherein the first transition metal dichalcogenide layer includes a highly crystalline transition metal dichalcogenide material having a two-dimensional crystal structure, and the second transition metal dichalcogenide layer includes a nano-crystalline grain transition metal dichalcogenide material having a two-dimensional crystal structure.

For example, a grain size of the second transition metal dichalcogenide layer may be 10 nm or less, and a grain size of the first transition metal dichalcogenide layer is 50 nm or more.

A distance between the first transition metal dichalcogenide layer and the second transition metal dichalcogenide layer may be 2 nm or less.

The first transition metal dichalcogenide layer may include the highly crystalline transition metal dichalcogenide material having the two-dimensional crystal structure stacked in 1 to 10 layers, and the second transition metal dichalcogenide layer may include the nano-crystalline grain transition metal dichalcogenide material having the two-dimensional crystal structure stacked in 1 to 10 layers.

An atomic ratio of a chalcogen element to a transition metal in the second transition metal dichalcogenide layer may be within ±20 % of an atomic ratio of a chalcogen element to a transition metal in the first transition metal dichalcogenide layer.

A proportion of metals having an oxidation number of +4 among all metals in the first transition metal dichalcogenide layer may be 80 % or more, and a proportion of metals having an oxidation number of +4 among all metals in the second transition metal dichalcogenide layer may be 80 % or more.

An atomic ratio of a chalcogen element to a transition metal in the first transition metal dichalcogenide layer and the second transition metal dichalcogenide layer may be 1.7 or more.

The channel layer may further include a third transition metal dichalcogenide layer disposed below the first transition metal dichalcogenide layer, the first transition metal dichalcogenide layer may be disposed between the third transition metal dichalcogenide layer and the second transition metal dichalcogenide layer, and the third transition metal dichalcogenide layer may include a nano-crystalline grain transition metal dichalcogenide material having a two-dimensional crystal structure.

The first transition metal dichalcogenide layer and the second transition metal dichalcogenide layer may include transition metal dichalcogenide materials having a same conductivity type.

The first transition metal dichalcogenide layer and the second transition metal dichalcogenide layer may include at least one of a same transition metal or a same chalcogen element.

The second transition metal dichalcogenide layer may include a first transition metal and a second transition metal, which are different from each other and a proportion of the first transition metal gradually increases and a proportion of the second transition metal gradually decreases along a thickness direction in the second transition metal dichalcogenide layer, or a first chalcogen element and a second chalcogen element, which are different from each other, and a proportion of the first chalcogen element gradually increases and a proportion of the second chalcogen element gradually decreases along the thickness direction in the second transition metal dichalcogenide layer.

The semiconductor device may further include a substrate, wherein the channel layer may be on the substrate, the source electrode and the drain electrode may be spaced apart from each other on the channel layer, the gate insulating film may be between the source electrode and the drain electrode on the channel layer, and the gate electrode may be on the gate insulating film.

The second transition metal dichalcogenide layer may include a first portion disposed between the first transition metal dichalcogenide layer and the source electrode and between the first transition metal dichalcogenide layer and the drain electrode, and a second portion disposed between the first transition metal dichalcogenide layer and the gate insulating film, and a thickness of the first portion may be greater than a thickness of the second portion.

The semiconductor device may further include a spacer between the gate electrode and the source electrode and between the gate electrode and the drain electrode, wherein the second transition metal dichalcogenide layer may further include a third portion between the first transition metal dichalcogenide layer and the spacer, and an absolute value of a difference in Fermi level between the first portion and the first transition metal dichalcogenide layer, an absolute value of a difference in Fermi level between the second portion and the first transition metal dichalcogenide layer, and an absolute value of a difference in Fermi level between the third portion and the first transition metal dichalcogenide layer may each be greater than zero.

The semiconductor device may further include a substrate, wherein the channel layer may protrude from the substrate in a first direction, the gate insulating film surrounds an upper surface of the channel layer and both side surfaces of the channel layer in a second direction perpendicular to the first direction, and the gate electrode surrounds an upper surface of the gate insulating film and both side surfaces of the gate insulating film in the second direction.

The semiconductor device may further include a substrate, wherein the channel layer may include a plurality of channel layers disposed at intervals from the substrate along a first direction, the gate insulating film comprises a plurality of gate insulating films surrounding lower and upper surfaces of each of the plurality of channel layers and both side surfaces of each of the plurality of channel layers in a second direction perpendicular to the first direction, and the gate electrode may protrude from the substrate in the first direction so as to surround the plurality of gate insulating films.

According to another aspect of the disclosure, a method of manufacturing a semiconductor device, includes forming a channel layer, the channel layer comprising a first transition metal dichalcogenide layer and a second transition metal dichalcogenide layer on the first transition metal dichalcogenide layer, forming a source electrode and a drain electrode such that the source electrode and the drain electrode are both electrically connected to the channel layer, and forming a gate insulating film and a gate electrode on the gate insulating film such that the gate insulating film insulates channel layer from the gate electrode, wherein the first transition metal dichalcogenide layer includes a highly crystalline transition metal dichalcogenide material having a two-dimensional crystal structure, and the second transition metal dichalcogenide layer includes a nano-crystalline grain transition metal dichalcogenide material having a two-dimensional crystal structure.

The forming of the channel layer may include depositing the highly crystalline transition metal dichalcogenide material at a first temperature and depositing the nano-crystalline grain transition metal dichalcogenide material at a second temperature that is lower than the first temperature.

According to another aspect of the disclosure, an electronic apparatus includes a transistor comprising a channel layer, a gate electrode facing the channel layer, a gate insulating film between the channel layer and the gate electrode, and a source electrode and a drain electrode electrically connected to the channel layer, a word line electrically connected to the gate electrode of the transistor, a bit line electrically connected to the source electrode of the transistor, and a capacitor electrically connected to the drain electrode of the transistor, wherein the channel layer includes a first transition metal dichalcogenide layer and a second transition metal dichalcogenide layer on the first transition metal dichalcogenide layer, and the first transition metal dichalcogenide layer includes a highly crystalline transition metal dichalcogenide material having a two-dimensional crystal structure, and the second transition metal dichalcogenide layer includes a nano-crystalline grain transition metal dichalcogenide material having a two-dimensional crystal structure.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a cross-sectional view schematically illustrating a structure of a semiconductor device according to at least one example embodiment;
FIG. 2 is a cross-sectional view schematically illustrating a structure of a semiconductor device according to at least one example embodiment;
FIGS. 3A to 3C are cross-sectional views schematically illustrating a process of forming a channel layer on a substrate;
FIG. 4 is a scanning electron microscope (SEM) image showing a nano-crystalline grain transition metal dichalcogenide layer grown on a highly crystalline transition metal dichalcogenide layer;
FIG. 5 is a transmission electron microscope (TEM) image showing a cross-section of the nano-crystalline grain transition metal dichalcogenide layer illustrated in FIG. 4;
FIGS. 6 and 7 are graphs showing examples of energy dispersive spectroscopy (EDS) spectra for a highly crystalline transition metal dichalcogenide layer and a nano-crystalline grain transition metal dichalcogenide layer, which are obtained through EDS analysis;
FIG. 8 is a graph showing a Raman spectrum for a nano-crystalline grain transition metal dichalcogenide layer;
FIG. 9 is a graph showing a Raman spectrum for a highly crystalline transition metal dichalcogenide layer;
FIG. 10 shows an example of current distribution in a plurality of semiconductor devices each including a channel layer according to at least one example embodiment;
FIG. 11 shows a comparative example of current distribution in a plurality of semiconductor devices each including a channel layer formed by a transfer method;
FIGS. 12 to 14 are cross-sectional views schematically illustrating structures of semiconductor devices according to at least some example embodiments;
FIG. 15 is a cross-sectional view schematically illustrating a structure of a semiconductor device according to at least one example embodiment;
FIGS. 16 to 18 are cross-sectional views schematically illustrating structures of semiconductor devices according to at least one example embodiment;
FIG. 19 is a perspective view schematically illustrating a structure of a semiconductor device according to at least some example embodiments;
FIG. 20 is a cross-sectional view schematically illustrating a channel layer and a gate electrode of the semiconductor device of FIG. 19 taken along line A-A' of FIG. 19;
FIG. 21 is a TEM image showing a stack structure in which aluminum oxides and MoS₂ layers are alternately grown;
FIGS. 22 to 25 are element mapping images showing element distributions of molybdenum (Mo), sulfur (S), aluminum (Al), and oxygen (O) in the stack structure illustrated in FIG. 21, respectively;
FIG. 26 is a graph showing a grain size of highly crystalline MoS₂ according to a thickness of an aluminum oxide layer;
FIG. 27 is a cross-sectional view schematically illustrating a channel layer and a gate electrode of a semiconductor device according to at least some example embodiments;
FIG. 28 is a cross-sectional view schematically illustrating a channel layer and a gate electrode of a semiconductor device according to at least some example embodiments;
FIG. 29 is a circuit diagram of a complementary metal-oxide semiconductor (CMOS) inverter according to at least one example embodiment;
FIG. 30 is a circuit diagram of a CMOS static random access memory (SRAM) device according to at least one example embodiment;
FIG. 31 is a circuit diagram of a CMOS dynamic random access memory (DRAM) device according to at least one example embodiment;
FIG. 32 is a block diagram of an electronic apparatus according to at least one example embodiment; and
FIG. 33 is a block diagram of an electronic apparatus according to at least one example embodiment.

### DETAILED DESCRIPTION

Reference will now be made in detail to some embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. Additionally, when the terms "about" or "substantially" are used in this specification in connection with a numerical value and/or geometric terms, it is intended that the associated numerical value includes a manufacturing tolerance (e.g., ±10%) around the stated numerical value. Further, regardless of whether numerical values and/or geometric terms are modified as "about" or "substantially," it will be understood that these values should be construed as including a manufacturing or operational tolerance (e.g., ±10%) around the stated numerical values and/or geometry. As used herein, the term "and/or" includes any and all combinations of one or more of the associated listed items. Expressions such as "at least one of," when preceding a list of elements, modify the entire list of elements and do not modify the individual elements of the list.

Hereinafter, a semiconductor device including a two-dimensional nano-crystalline grain channel, a method of manufacturing the semiconductor device, and an electronic apparatus including the semiconductor device are described in detail. In the following drawings, the same reference numerals denote the same elements, and the size of each element in the drawings may be exaggerated for clarity and convenience of explanation. In addition, embodiments described herein are merely examples, and various modifications may be made thereto from these embodiments.

Hereinafter, the terms "above," "on," "below," or "under" may include not only those that are directly above, below, left, or right in a contact manner, but also those that are above, below, left, or right in a non-contact manner. For example, such spatially relative terms are represented herein based on the direction illustrated in the drawings and may be represented otherwise when the orientation of the corresponding object changes. In other words, such spatially relative terms are intended to encompass different orientations of the device in use or operation in addition to the orientation depicted in the figures, such that the device may be otherwise oriented (rotated 90 degrees or at other orientations) and the spatially relative terms used herein interpreted accordingly. The singular forms as used herein are intended to include the plural forms as well unless the context clearly indicates otherwise. It will be understood that the terms "comprise," "include," or "have" as used herein specify the presence of stated elements, but do not preclude the presence or addition of one or more other elements.

The use of the term "the" and similar demonstratives may correspond to both the singular and the plural. Operations constituting methods may be performed in any suitable order unless otherwise indicated herein or otherwise clearly contradicted by context, and are not necessarily limited to the stated order.

Also, the terms such as "unit" and "module" described in the specification mean units that process at least one function or operation, and may be implemented as processing circuitry, such as hardware, software, or a combination of hardware and software. For example, the processing circuitry may include, but is not limited to, a central processing unit (CPU), an application processor (AP), an arithmetic logic unit (ALU), a graphic processing unit (GPU), a digital signal processor, a microcomputer, a field programmable gate array (FPGA), a System-on-Chip (SoC), a programmable logic unit, a microprocessor, or an application-specific integrated circuit (ASIC), etc., unless expressly indicated otherwise.

Connecting lines or connecting members illustrated in the drawings are intended to represent example functional relationships and/or physical or logical connections between the various elements. It should be noted that many alternative or additional functional relationships, physical connections or logical connections may be present in a practical device.

The use of all illustrations or illustrative terms in the embodiments is simply to describe the technical ideas in detail, and the scope of the disclosure is not limited by the illustrations or illustrative terms unless they are limited by claims.

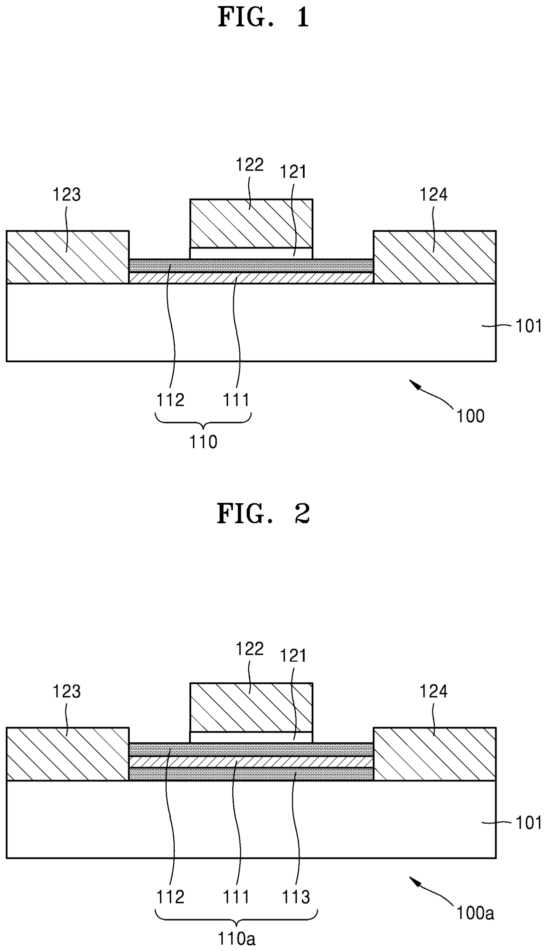

FIG. 1 is a cross-sectional view schematically illustrating a structure of a semiconductor device 100 according to at least one example embodiment. Referring to FIG. 1, the semiconductor device 100 according to at least one example embodiment includes a channel layer 110, a gate insulating film 121 disposed on the channel layer 110, a gate electrode 122 disposed on the gate insulating film 121, and a source electrode 123 and a drain electrode 124 electrically connected through the channel layer 110 when the semiconductor device 100 is switched on. In other words, the channel layer 110 may be provided between the source electrode 123 and the drain electrode 124 to be electrically connected to both the source electrode 123 and the drain electrode 124. The gate electrode 122 may be disposed to face the channel layer 110, and the gate insulating film 121 may be disposed between the channel layer 110 and the gate electrode 122 and insulates the channel layer 110 from the gate electrode 122.

The semiconductor device 100 may be, for example, a field effect transistor (FET). In particular, the semiconductor device 100 may be an FET having a top gate structure in which the gate electrode 122 is disposed above the channel layer 110. In this case, the gate electrode 122, the source electrode 123, and the drain electrode 124 may be disposed on the same side with respect to a substrate 101. For example, the gate electrode 122, the source electrode 123, and the drain electrode 124 may all be disposed to face the upper surface of the substrate 101.

The semiconductor device 100 may also further include the substrate 101. The substrate 101 may be an insulating substrate including, for example, at least one of glass, plastic, a dielectric, and/or the like. The channel layer 110, the source electrode 123, and the drain electrode 124 may be disposed on the substrate 101. The source electrode 123 and the drain electrode 124 may be respectively in contact with both sides of the channel layer 110 on the substrate 101. For example, the source electrode 123 may be electrically connected to a first side surface of the channel layer 110, and the drain electrode 124 may be electrically connected to a second side surface of the channel layer 110 opposite to the first side surface.

The gate insulating film 121 may include an insulating material having a high dielectric constant of about 10 or more. For example, the gate insulating film 121 may include at least one of hafnium oxide (HfO), aluminum oxide (AlO), tantalum oxide (TaO), and/or the like. Although FIG. 1 illustrates that the width of the gate insulating film 121 is less than the width of the channel layer 110, the width of the gate insulating film 121 may be equal to the width of the channel layer 110.

The channel layer 110 may include a semiconductor material having a two-dimensional crystal structure. For example, the channel layer 110 may include a transition metal dichalcogenide material. According to at least some example embodiments, the transition metal dichalcogenide is a compound of a transition metal and a chalcogen element. In other words, the channel layer 110 may include a semiconductive MX₂, wherein M is a transition metal and X is a chalcogen element. The transition metal M may include at least one of molybdenum (Mo), tungsten (W), hafnium (Hf), zirconium (Zr), tantalum (Ta), titanium (Ti), rhenium (Re), niobium (Nb), tin (Sn), and platinum (Pt). The chalcogen element X may include at least one of sulfur (S), selenium (Se), and tellurium (Te). The channel layer 110 may include, for example, MoS₂, MoSe₂, MoTe₂, WS₂, WSe₂, TiS₂, ZrS₂, ZrSe₂, HfS₂, PtSe₂, PtS₂, SnS₂, TaS₂, ReS₂, NbS₂, TaSe₂, HfSe₂, ReSe₂, TiSe₂, NbSe₂, SnSe₂, WTe₂, TaTe₂, HfTe₂, ReTe₂, TiTe₂, NbTe₂, SnTe₂, etc.

The transition metal dichalcogenide may have excellent properties even at a relatively small thickness of, for example, 1 nm or less, and may be easy to control in terms of the properties thereof. Accordingly, the channel layer 110 including the transition metal dichalcogenide material is advantageous for miniaturization of the semiconductor device 100. On the other hand, the channel layer 110 according to at least one example embodiment may include at least two layers having different grain sizes in order to prevent or alleviate deterioration due to damage caused by the channel layer 110 being peeled off from the substrate 101 during the manufacturing process due to the low bonding strength between the substrate 101 and the channel layer 110. For example, the channel layer 110 may include a first transition metal dichalcogenide layer 111 and a second transition metal dichalcogenide layer 112. The first transition metal dichalcogenide layer 111 may be disposed on the substrate 101. The second transition metal dichalcogenide layer 112 may be disposed on the first transition metal dichalcogenide layer 111 and may be in direct contact with the first transition metal dichalcogenide layer 111. The gate insulating film 121 may be disposed on the second transition metal dichalcogenide layer 112. Accordingly, the first transition metal dichalcogenide layer 111 may be disposed between the substrate 101 and the second transition metal dichalcogenide layer 112, and the second transition metal dichalcogenide layer 112 may be disposed between the first transition metal dichalcogenide layer 111 and the gate insulating film 121.

The first transition metal dichalcogenide layer 111 may include a highly crystalline transition metal dichalcogenide material having a two-dimensional crystal structure, and the second transition metal dichalcogenide layer 112 may include a nano-crystalline grain transition metal dichalcogenide material having a two-dimensional crystal structure. For example, the grain size (L_{G2}) of the second transition metal dichalcogenide layer 112 may be greater than 0 nanometers (nm) and less than or equal to about 10 nm (e.g., 0 nm < L_{G2} ≤ about 10 nm), and the grain size (L_{G1}) of the first transition metal dichalcogenide layer 111 may be greater than or equal to about 5 times the grain size of the second transition metal dichalcogenide layer 112. For example, the grain size of the first transition metal dichalcogenide layer 111 may be 50 nm or more, about 100 nm or more, and/or about 200 nm or more, and about 1,000 nm or less.

The first transition metal dichalcogenide layer 111 may be provided by stacking a highly crystalline transition metal dichalcogenide material having a two-dimensional structure in one to ten layers and/or one to three layers. The second transition metal dichalcogenide layer 112 may be provided by stacking a nano-crystalline grain transition metal dichalcogenide material having a two-dimensional structure in one to ten layers and/or one to three layers. For example, the thickness of each of the first and second transition metal dichalcogenide layers 111 and 112 may be about 0.7 nm to about 7 nm, and/or about 0.7 nm to about 2.5 nm.

The first transition metal dichalcogenide layer 111 and the second transition metal dichalcogenide layer 112 may include the same transition metal dichalcogenide material and have different grain sizes. Alternatively, the first transition metal dichalcogenide layer 111 and the second transition metal dichalcogenide layer 112 may include different transition metal dichalcogenide materials and have different grain sizes. In other words, the first transition metal dichalcogenide layer 111 and the second transition metal dichalcogenide layer 112 may include the same transition metal and the same chalcogen element and have different grain sizes, may include the same transition metal and different chalcogen elements and have different grain sizes, or may include different transition metals and different chalcogen elements and have different grain sizes. A threshold voltage of the semiconductor device 100 may be determined according to a band gap of the first transition metal dichalcogenide layer 111 and of the second transition metal dichalcogenide layer 112. The threshold voltage of the semiconductor device 100 may be controlled to a desired value by selecting materials of the first transition metal dichalcogenide layer 111 and the second transition metal dichalcogenide layer 112.

When the material of the first transition metal dichalcogenide layer 111 is different from the material of the second transition metal dichalcogenide layer 112, materials having an electrically identical conductivity type (or polarity) may be selected as the materials of the first and second transition metal dichalcogenide layers 111 and 112. For example, when the first transition metal dichalcogenide layer 111 includes an n-type transition metal dichalcogenide material, the second transition metal dichalcogenide layer 112 may also include an n-type transition metal dichalcogenide material. Alternatively, when the first transition metal dichalcogenide layer 111 includes a p-type transition metal dichalcogenide material, the second transition metal dichalcogenide layer 112 may also include a p-type transition metal dichalcogenide material. Examples of the n-type transition metal dichalcogenide material may include MoS₂, MoSe₂, WS₂, HfS₂, ZrS₂, and/or the like, and examples of the p-type transition metal dichalcogenide material may include WSe₂, MoTe₂, WTe₂, HfTe₂, and/or the like.

In addition, when the first transition metal dichalcogenide layer 111 and the second transition metal dichalcogenide layer 112 include different transition metal dichalcogenide materials, it may be advantageous in the manufacturing process when the first transition metal dichalcogenide layer 111 and the second transition metal dichalcogenide layer 112 include the same chalcogen element. In addition, the first transition metal dichalcogenide layer 111 and the second transition metal dichalcogenide layer 112 including the same chalcogen element may have electrically similar properties. For example, the transition metal dichalcogenide materials of the first transition metal dichalcogenide layer 111 and the second transition metal dichalcogenide layer 112 may both include sulfur (S), may both include selenium (Se), or may both include tellurium (Te).

According to at least one example embodiment, the crystal orientation of the first transition metal dichalcogenide layer 111 may be identical to or different from the crystal orientation of the second transition metal dichalcogenide layer 112. For example, in at least one example embodiment, one of the first transition metal dichalcogenide layer 111 and the second transition metal dichalcogenide layer 112 may have, as a dominant crystal orientation, a zigzag crystal orientation and the other may have, as a dominant crystal orientation, an armchair crystal orientation, e.g., oriented in the direction between the source electrode 123 and the drain electrode 124. When the crystal orientation of the first transition metal dichalcogenide layer 111 is different from the crystal orientation of the second transition metal dichalcogenide layer 112, the effect of decreasing the band gap as the number of stacks of the second transition metal dichalcogenide layer 112 increases may be reduced. Accordingly, leakage current may be reduced or suppressed by controlling the crystal orientations of the first transition metal dichalcogenide layer 111 and the second transition metal dichalcogenide layer 112 and the number of stacks of the first transition metal dichalcogenide layer 111 and the second transition metal dichalcogenide layer 112.

FIG. 2 is a cross-sectional view schematically illustrating a structure of a semiconductor device 100a according to at least one example embodiment. Although FIG. 1 illustrates that the channel layer 110 includes two layers with different grain sizes, the disclosure is not limited thereto. Referring to FIG. 2, a channel layer 110a of the semiconductor device 100a may further include a third transition metal dichalcogenide layer 113 disposed below the first transition metal dichalcogenide layer 111. The remaining elements of the semiconductor device 100a may be the same as those of the semiconductor device 100 illustrated in FIG. 1.

The third transition metal dichalcogenide layer 113 may be disposed between the substrate 101 and the first transition metal dichalcogenide layer 111. In other words, the third transition metal dichalcogenide layer 113 may be disposed on the substrate 101, the first transition metal dichalcogenide layer 111 may be disposed on the third transition metal dichalcogenide layer 113, and the second transition metal dichalcogenide layer 112 may be disposed on the first transition metal dichalcogenide layer 111. In these cases, the first transition metal dichalcogenide layer 111 may be disposed between the third transition metal dichalcogenide layer 113 and the second transition metal dichalcogenide layer 112. Like the second transition metal dichalcogenide layer 112, the third transition metal dichalcogenide layer 113 may include a nano-crystalline grain transition metal dichalcogenide material having a two-dimensional crystal structure. For example, the grain size of the third transition metal dichalcogenide layer 113 may be about 10 nm or less. The third transition metal dichalcogenide layer 113 may be provided by stacking a nano-crystalline grain transition metal dichalcogenide material having a two-dimensional structure in one to ten layers or one to three layers. For example, the thickness of the third transition metal dichalcogenide layer 113 may be about 0.7 nm to about 7 nm, or about 0.7 nm to about 2.5 nm. The third transition metal dichalcogenide layer 113 may include a material that is identical to or different from a material of each of the first and second transition metal dichalcogenide layers 111 and 112. Even when the third transition metal dichalcogenide layer 113 includes a material that is different from a material of each of the first and second transition metal dichalcogenide layers 111 and 112, materials having an electrically identical conductivity type may be selected as the material of the first to third transition metal dichalcogenide layers 111, 112, and 113.

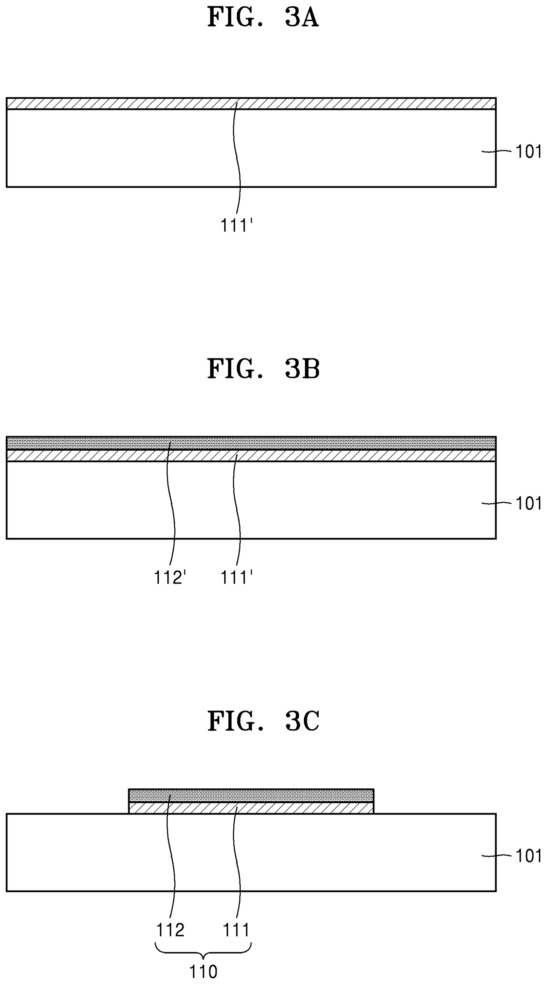

According to at least one example embodiment, the channel layer 110 may be provided by direct growth on the substrate 101. FIGS. 3A to 3C are cross-sectional views schematically illustrating a process of forming the channel layer 110 on the substrate 101.

Referring to FIG. 3A, a highly crystalline transition metal dichalcogenide material 111' may be grown on the substrate 101. The highly crystalline transition metal dichalcogenide material 111' may be deposited and grown at a first temperature of about 400 degrees Celsius (°C) or higher, for example, about 600 °C, by chemical vapor deposition (CVD), plasma enhanced CVD (PE-CVD), or inductively coupled plasma chemical vapor deposition (ICP-CVD).

Referring to FIG. 3B, a nano-crystalline grain transition metal dichalcogenide material 112' may be grown on the highly crystalline transition metal dichalcogenide material 111'. The nano-crystalline grain transition metal dichalcogenide material 112' may be grown at a second temperature lower than the first temperature. For example, in at least some example embodiments, the second temperature may be about 127 °C or higher and lower than about 400 °C, which is lower than the first temperature. For example, the nano-crystalline grain transition metal dichalcogenide material 112' may be deposited and grown at a temperature of 350 °C by CVD, PE-CVD, or ICP-CVD.

Referring to FIG. 3C, the channel layer 110 including the first transition metal dichalcogenide layer 111 and the second transition metal dichalcogenide layer 112 may be formed by patterning the highly crystalline transition metal dichalcogenide material 111' and the nano-crystalline grain transition metal dichalcogenide material 112'. Although FIG. 3C illustrates that the highly crystalline transition metal dichalcogenide material 111' and the nano-crystalline grain transition metal dichalcogenide material 112' are simultaneously patterned, the disclosure is not limited thereto. For example, after the first transition metal dichalcogenide layer 111 is formed by patterning the highly crystalline transition metal dichalcogenide material 111' in the operation illustrated in FIG. 3A, the nano-crystalline grain transition metal dichalcogenide material 112' may be grown to cover the substrate 101 and the first transition metal dichalcogenide layer 111, and then, the nano-crystalline grain transition metal dichalcogenide material 112' may be patterned.

After the channel layer 110 is formed, a gate insulating film material may be deposited to a uniform thickness to cover the substrate 101 and the channel layer 110, and then, a gate insulating film 121 may be formed on the channel layer 110 by patterning the gate insulating film material through an etching process. A conductive material may be deposited to a uniform thickness over the substrate 101, the channel layer 110, and the gate insulating film 121, and then, the gate electrode 122, the source electrode 123, and the drain electrode 124 may be formed by patterning the conductive material through an etching process. In this manner, the semiconductor device 100 may be manufactured. For example, the conductive materials remaining on both sides of the channel layer 110 may become the source electrode 123 and the drain electrode 124, and the conductive material remaining on the gate insulating film 121 may become the gate electrode 122.

According to at least one example embodiment, the second transition metal dichalcogenide layer 112 including the nano-crystalline grain transition metal dichalcogenide material may reduce or prevent the first transition metal dichalcogenide layer 111 from being peeled off from the substrate 101, e.g., by shielding the first transition metal dichalcogenide layer 111 from a chemical material, such as a developer, which may otherwise penetrates into the first transition metal dichalcogenide layer 111 in the process of patterning the channel layer 110 during the manufacture of the semiconductor device 100, as illustrated in FIG. 3C. In addition, the second transition metal dichalcogenide layer 112 may reduce or prevent the first transition metal dichalcogenide layer 111 from being damaged, oxidized, or contaminated by exposure to heat, oxygen, or various other chemicals during the process of manufacturing the semiconductor device 100. In addition, because high-density grain boundaries exist in the nano-crystalline grain transition metal dichalcogenide material of the second transition metal dichalcogenide layer 112, an insulator may be uniformly deposited on the second transition metal dichalcogenide layer 112 by using the highly-density grain boundaries as seeding points. Accordingly, the gate insulating film 121 and the gate electrode 122 may be deposited with high quality on the channel layer 110.

During the process of growing the channel layer 110, the first transition metal dichalcogenide layer 111 and the second transition metal dichalcogenide layer 112 are protected from being oxidized and are not doped or substituted with other heterogeneous elements. Therefore, the atomic ratio of the chalcogen element X to the transition metal M in the first transition metal dichalcogenide layer 111 and the second transition metal dichalcogenide layer 112 may be maintained at, for example, about 1.7 or more. In at least some example embodiments, the atomic ratio of the chalcogen element X to the transition metal M is 2, and even when a slight defect occurs in the first transition metal dichalcogenide layer 111 and the second transition metal dichalcogenide layer 112, the atomic ratio of the chalcogen element X to the transition metal M may not become less than 1.7. In addition, a proportion of metals having an oxidation number of +4 among all metals in the first transition metal dichalcogenide layer 111 may be 80 % or more. Similarly, a proportion of metals having an oxidation number of +4 among all metals in the second transition metal dichalcogenide layer 112 may be 80 % or more.

In addition, the atomic ratio of the chalcogen element X to the transition metal M in the first transition metal dichalcogenide layer 111 may be equal to and/or substantially similar to the atomic ratio of the chalcogen element X to the transition metal M in the second transition metal dichalcogenide layer 112. For example, the atomic ratio of the chalcogen element X to the transition metal M in the second transition metal dichalcogenide layer 112 may be within about ±20 % of the atomic ratio of the chalcogen element X to the transition metal M in the first transition metal dichalcogenide layer 111.

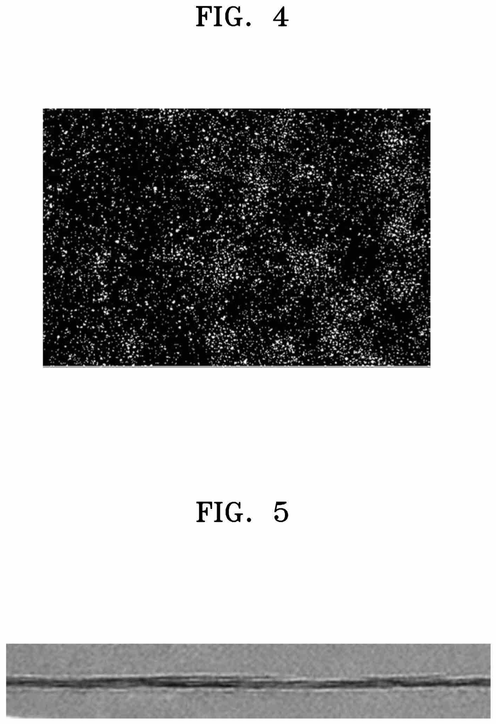

FIG. 4 is a scanning electron microscope (SEM) image showing a nano-crystalline grain transition metal dichalcogenide layer grown on a highly crystalline transition metal dichalcogenide layer. In addition, FIG. 5 is a transmission electron microscope (TEM) image showing a cross-section of the nano-crystalline grain transition metal dichalcogenide layer illustrated in FIG. 4. A highly crystalline transition metal dichalcogenide layer including MoS₂ was directly grown on a catalyst at a temperature of about 600 °C, and then, a nano-crystalline grain transition metal dichalcogenide layer including MoS₂ was grown on the highly crystalline transition metal dichalcogenide layer at a temperature of about 350 °C. Referring to FIG. 4, it may be confirmed that the nano-crystalline grain transition metal dichalcogenide layer has a relatively homogeneous surface. In addition, referring to FIG. 5, it may be confirmed that the nano-crystalline grain transition metal dichalcogenide layer is grown to a relatively uniform thickness.

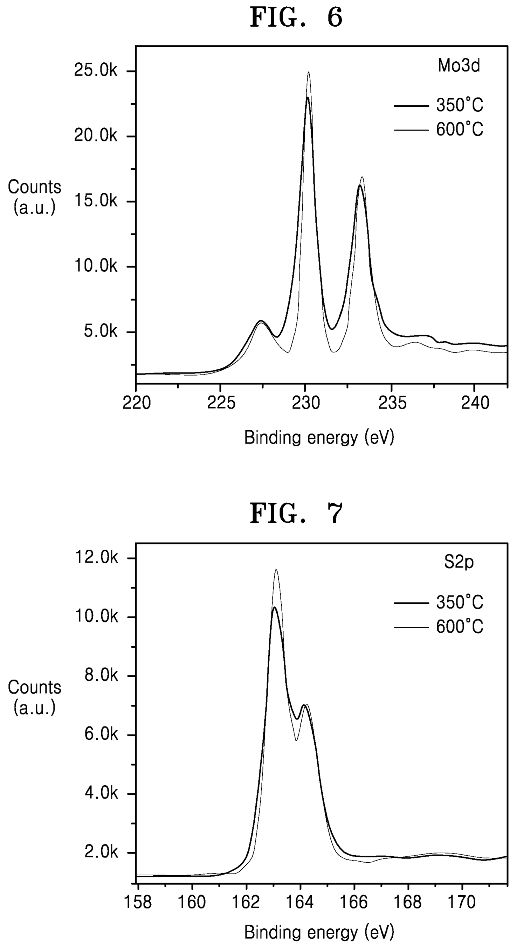

The grain size and elemental composition of the first transition metal dichalcogenide layer 111 and the second transition metal dichalcogenide layer 112 of the channel layer 110 may be confirmed through, for example, cross-sectional TEM analysis, energy dispersive spectroscopy (EDS), electron energy loss spectroscopy (EELS), Raman spectroscopy, etc. FIGS. 6 and 7 are graphs showing examples of EDS spectra for the highly crystalline transition metal dichalcogenide layer and the nano-crystalline grain transition metal dichalcogenide layer, which were obtained through EDS analysis. The highly crystalline transition metal dichalcogenide layer includes MoS₂ grown at a temperature of 600 °C, and the nano-crystalline grain transition metal dichalcogenide layer includes MoS₂ grown at a temperature of 350 °C. FIG. 6 shows an EDS analysis result for a 3d orbital of molybdenum (Mo), and FIG. 7 shows an EDS analysis results for a 2p orbital of sulfur (S). Referring to FIGS. 6 and 7, it may be confirmed that the highly crystalline transition metal dichalcogenide layer and the nano-crystalline grain transition metal dichalcogenide layer have the same composition because the spectral peak occurs at the same energy. In addition, because the full width at half maximum (FWHM) of the graph for the nano-crystalline grain transition metal dichalcogenide layer is greater than the FWHM of the graph for the highly crystalline transition metal dichalcogenide layer, it may be confirmed that the grain size of the nano-crystalline grain transition metal dichalcogenide layer is less than the grain size of the highly crystalline transition metal dichalcogenide layer.

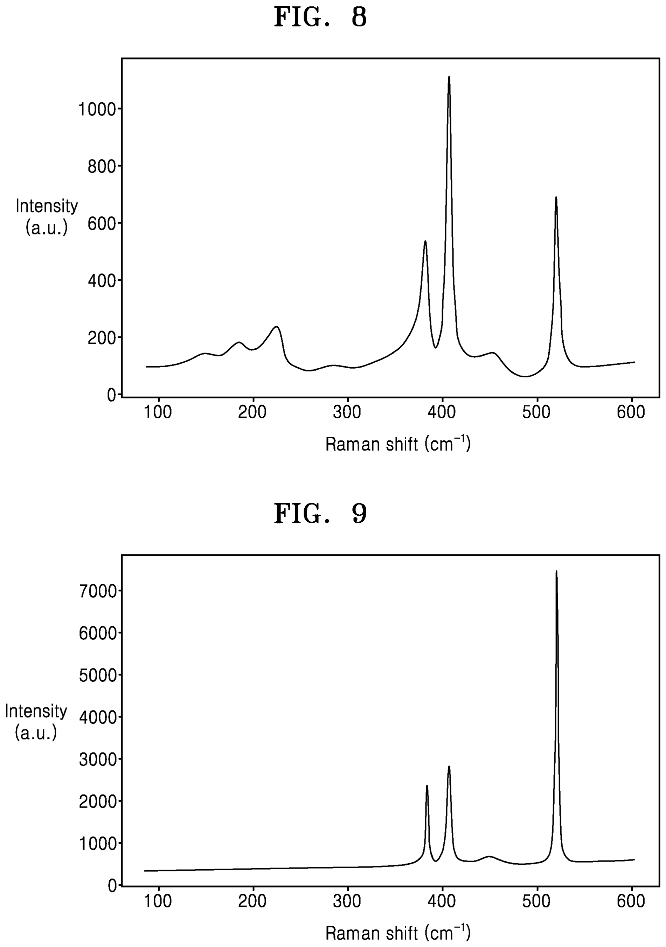

FIG. 8 is a graph showing a Raman spectrum for the nano-crystalline grain transition metal dichalcogenide layer, and FIG. 9 is a graph showing a Raman spectrum for the highly crystalline transition metal dichalcogenide layer. Referring to FIGS. 8 and 9, it may be confirmed that, even when the highly crystalline transition metal dichalcogenide layer and the nano-crystalline grain transition metal dichalcogenide layer include the same material (MoS₂), different peaks appear depending on the grain size. Through the analyses described above, the first transition metal dichalcogenide layer 111 and the second transition metal dichalcogenide layer 112 of the channel layer 110 may be distinguished from each other.

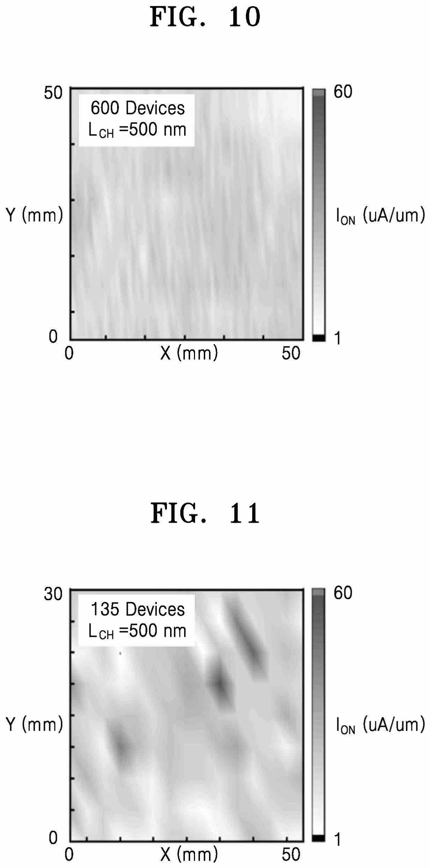

On the other hand, as illustrated in FIGS. 3A to 3C, because the channel layer 110 is formed by a direct growth method rather than a transfer method, the quality of the channel layer 110 is relatively less sensitive to the surface condition of the substrate 101, and thus, the channel layer 110 may be formed relatively homogeneously over the entire region of the substrate 101 or wafer. FIG. 10 shows an example of current distribution in a plurality of semiconductor devices each including a channel layer according to at least one example embodiment, and FIG. 11 shows a comparative example of current distribution in a plurality of semiconductor devices each including a channel layer formed by a transfer method. In particular, FIGS. 10 and 11 show the results of, after a plurality of semiconductor devices are formed on a wafer, measuring source-drain current for the plurality of semiconductor devices disposed in a partial square region of the wafer. For example, FIG. 10 shows the results of measuring the source-drain current for 600 semiconductor devices disposed in a partial square region of the wafer and FIG. 11 shows the results of measuring the source-drain current for 135 semiconductor devices disposed in a partial square region of the wafer. Referring to FIGS. 10 and 11, it may be confirmed that the current deviation is relatively small between the plurality of semiconductor devices according to the embodiment, whereas the current deviation is relatively large between the plurality of semiconductor devices including the channel layer formed by the transfer method.

The method of forming the channel layer 110 may be distinguished through the distance between the layers. For example, when the first transition metal dichalcogenide layer 111 is directly grown on the substrate 101 and the second transition metal dichalcogenide layer 112 is directly grown on the first transition metal dichalcogenide layer 111, almost no empty space occurs between the layers. For example, the distance between the substrate 101 and the first transition metal dichalcogenide layer 111 may be 2 nm or less, and the distance between the first transition metal dichalcogenide layer 111 and the second transition metal dichalcogenide layer 112 may be 2 nm or less. On the other hand, when the first transition metal dichalcogenide layer 111 and the second transition metal dichalcogenide layer 112 are formed by the transfer method, an empty space is formed between the layers, and thus, the distance between the layers may be greater than 2 nm.

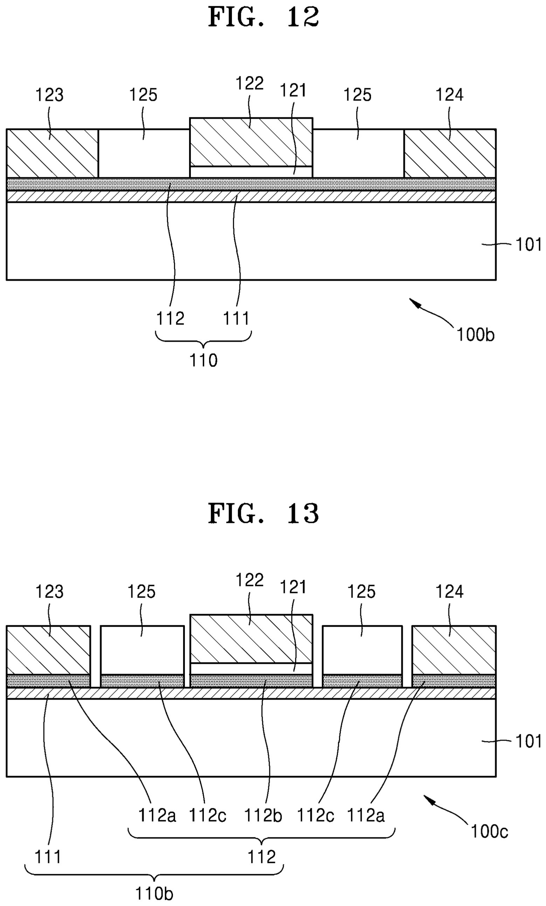

FIG. 12 is a cross-sectional view schematically illustrating a structure of a semiconductor device 100b according to at least some example embodiments. In the semiconductor devices 100 and 100a illustrated in FIGS. 1 and 2, the source electrode 123 and the drain electrode 124 are directly disposed on the substrate 101 and the channel layer 110 is disposed between the source electrode 123 and the drain electrode 124, but the disclosure is not necessarily limited thereto. Referring to FIG. 12, a semiconductor device 100b may include a substrate 101, a channel layer 110 on the substrate 101, a source electrode 123 and a drain electrode 124 spaced apart from each other on the channel layer 110, a gate insulating film 121 between the source electrode 123 and the drain electrode 124 on the channel layer 110, and a gate electrode 122 on the gate insulating film 121. The gate electrode 122, the source electrode 123, and the drain electrode 124 may all be disposed above the channel layer 110. The source electrode 123 and the drain electrode 124 may be disposed to face each other on both sides of the gate insulating film 121 on the upper surface of the channel layer 110. The source electrode 123 and the drain electrode 124 may be spaced apart from and not be in direct contact with the substrate 101. In other words, the channel layer 110 may be disposed between the source electrode 123 and the substrate 101 and between the drain electrode 124 and the substrate 101.

The channel layer 110 may include a first transition metal dichalcogenide layer 111 on the substrate 101 and a second transition metal dichalcogenide layer 112 on the first transition metal dichalcogenide layer 111. The source electrode 123, the drain electrode 124, and the gate insulating film 121 may be disposed on the second transition metal dichalcogenide layer 112.

In at least some example embodiments, the channel layer 110 of the semiconductor device 100b may further include the third transition metal dichalcogenide layer 113 illustrated in FIG. 2. For example, the channel layer 110 may further include the third transition metal dichalcogenide layer 113 disposed below the first transition metal dichalcogenide layer 111. In these cases, the third transition metal dichalcogenide layer 113 may be disposed on the substrate 101, the first transition metal dichalcogenide layer 111 may be disposed on the third transition metal dichalcogenide layer 113, and the second transition metal dichalcogenide layer 112 may be disposed on the first transition metal dichalcogenide layer 111.

In addition, the semiconductor device 100b may further include a spacer 125 that electrically separates the gate electrode 122 from the source electrode 123 and electrically separates the gate electrode 122 from the drain electrode 124. The spacer 125 may be disposed between the gate electrode 122 and the source electrode 123 and between the gate electrode 122 and the drain electrode 124 on the channel layer 110, particularly on the second transition metal dichalcogenide layer 112. The spacer 125 may include an insulating dielectric. For example, the spacer 125 may include at least one material selected from silicon oxide (SiO₂), silicon nitride (SiNₓ), and silicon oxynitride (SiON). However, in at least some example embodiments, the spacer 125 may be omitted when the gate electrode 122 and the source electrode 123 are sufficiently electrically separated from each other and the gate electrode 122 and the drain electrode 124 are sufficiently electrically separated from each other.

FIG. 13 is a cross-sectional view schematically illustrating a structure of a semiconductor device 100c according to at least some example embodiments. A second transition metal dichalcogenide layer 112 may be divided into portions having different materials by taking into account characteristics of a gate insulating film 121, a source electrode 123, a drain electrode 124, and a spacer 125 thereon. Referring to FIG. 13, a channel layer 110b of the semiconductor device 100c may include a first transition metal dichalcogenide layer 111 and a second transition metal dichalcogenide layer 112 disposed on the first transition metal dichalcogenide layer 111. The second transition metal dichalcogenide layer 112 may be divided into a plurality of portions. For example, the second transition metal dichalcogenide layer 112 may include a first portion 112a, a second portion 112b, and a third portion 112c. The first portion 112a may be disposed between the first transition metal dichalcogenide layer 111 and the source electrode 123 and between the first transition metal dichalcogenide layer 111 and the drain electrode 124. The second portion 112b may be disposed between the first transition metal dichalcogenide layer 111 and the gate insulating film 121. The third portion 112c may be disposed between the first transition metal dichalcogenide layer 111 and the spacer 125. The first portion 112a, the second portion 112b, and the third portion 112c may be spaced apart from each other on the first transition metal dichalcogenide layer 111.

In at least one example embodiment, the first portion 112a, the second portion 112b, and the third portion 112c may include the same nano-crystalline grain transition metal dichalcogenide material. In at least one example embodiment, the first portion 112a, the second portion 112b, and the third portion 112c may include different nano-crystalline grain transition metal dichalcogenide materials by taking into account the functions of the layers respectively disposed on the first portion 112a, the second portion 112b, and the third portion 112c.

The first portion 112a disposed below the source electrode 123 or the drain electrode 124 may include a transition metal dichalcogenide material having semiconductor properties or metallic properties selected to reduce contact resistance. For example, the first portion 112a may include a transition metal dichalcogenide material based on a noble metal, such as platinum (Pt), or a transition metal dichalcogenide material having a 1T or 1T' crystalline phase. In addition, the first portion 112a may include a transition metal dichalcogenide material selected to provide a doping effect to the first transition metal dichalcogenide layer 111 there below. For example, when the channel layer 110 is n-type, the first portion 112a may include a transition metal dichalcogenide material having a Fermi level higher than a Fermi level of the transition metal dichalcogenide material of the first transition metal dichalcogenide layer 111. When the channel layer 110 is p-type, the first portion 112a may include a transition metal dichalcogenide material having a Fermi level lower than a Fermi level of the transition metal dichalcogenide material of the first transition metal dichalcogenide layer 111. Accordingly, an absolute value of the difference in Fermi level between the first transition metal dichalcogenide layer 111 and the first portion 112a may be greater than zero. For example, the first portion 112a may include PtSe₂, PtS₂, 1T-phase-MoS₂, 1T'-phase-MoTe₂, etc. The electrical conductivity may be improved and the contact resistance may be reduced in a contact region between the source electrode 123 and the first portion 112a and a contact region between the drain electrode 124 and the first portion 112a.

The third portion 112c disposed below the spacer 125 may include a transition metal dichalcogenide material that has the same conductivity type (or electrical polarity) as the first transition metal dichalcogenide layer 111 there below and may have semiconductor properties capable of providing a doping effect to the first transition metal dichalcogenide layer 111. For example, when the channel layer 110 is n-type, the third portion 112c may include a transition metal dichalcogenide material having a Fermi level higher than a Fermi level of the transition metal dichalcogenide material of the first transition metal dichalcogenide layer 111. When the channel layer 110 is p-type, the third portion 112c may include a transition metal dichalcogenide material having a Fermi level lower than a Fermi level of the transition metal dichalcogenide material of the first transition metal dichalcogenide layer 111. Accordingly, an absolute value of the difference in Fermi level between the first transition metal dichalcogenide layer 111 and the third portion 112c may be greater than zero. The doping effect of the first transition metal dichalcogenide layer 111 by the third portion 112c may be the same as the doping effect of the first transition metal dichalcogenide layer 111 by the first portion 112a, but the disclosure is not limited thereto, and the doping effect of the first transition metal dichalcogenide layer 111 by the third portion 112c may be slightly larger or smaller than the doping effect of the first transition metal dichalcogenide layer 111 by the first portion 112a.

The second portion 112b disposed below the gate insulating film 121 may include a transition metal dichalcogenide material having semiconductor properties having the same conductivity type (or electrical polarity) as the first transition metal dichalcogenide layer 111 therebelow. In addition, the second portion 112b may include a transition metal dichalcogenide material that is different from the first transition metal dichalcogenide layer 111 so as to provide a doping effect to the first transition metal dichalcogenide layer 111. Accordingly, in the case of the second portion 112b, an absolute value of the difference in Fermi level between the first transition metal dichalcogenide layer 111 and the second portion 112b may be greater than zero. The threshold voltage of the semiconductor device 100c may be controlled according to the Fermi level of the second portion 112b. Because the doping effect of the second portion 112b on the first transition metal dichalcogenide layer 111 is to control the threshold voltage, the Fermi level of the second portion 112b may be higher or lower than the Fermi level of the first transition metal dichalcogenide layer 111, regardless of the conductivity type of the channel layer 110.

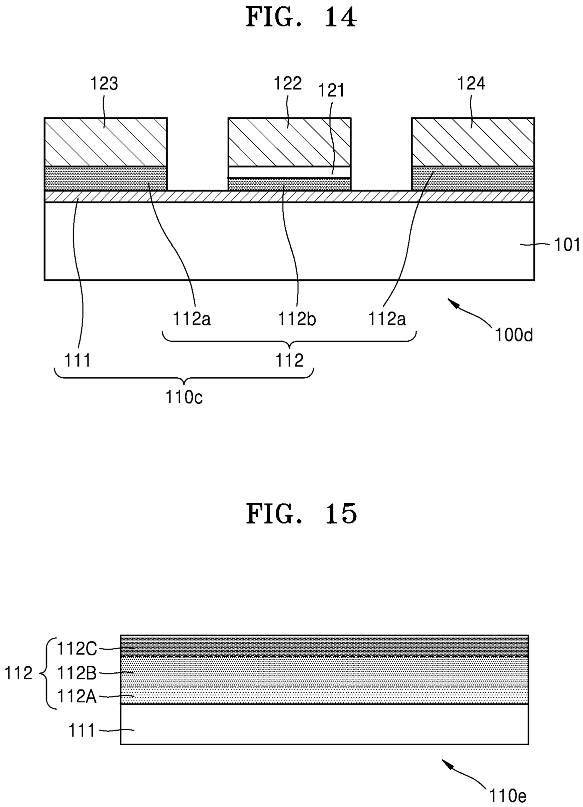

FIG. 14 is a cross-sectional view schematically illustrating a structure of a semiconductor device 100d according to at least some example embodiments. A second transition metal dichalcogenide layer 112 may be divided to have different thicknesses by taking into account characteristics of a gate insulating film 121, a source electrode 123, and a drain electrode 124 there above. Referring to FIG. 14, a channel layer 110c of the semiconductor device 100d may include a first transition metal dichalcogenide layer 111 and a second transition metal dichalcogenide layer 112 disposed on the first transition metal dichalcogenide layer 111. The second transition metal dichalcogenide layer 112 may be divided into a plurality of portions. For example, the second transition metal dichalcogenide layer 112 may include a first portion 112a disposed between the first transition metal dichalcogenide layer 111 and the source electrode 123 and between the first transition metal dichalcogenide layer 111 and the drain electrode 124, and a second portion 112b disposed between the first transition metal dichalcogenide layer 111 and the gate insulating film 121. The first portion 112a and the second portion 112b may be spaced apart from each other on the first transition metal dichalcogenide layer 111. The semiconductor device 100d may further include the spacer 125 illustrated in FIG. 13, and the channel layer 110c may further include the third portion 112c illustrated in FIG. 13.

In general, as the number of stacks of a transition metal dichalcogenide material increases, that is, as the thickness increases, the band gap may decrease, and the conductivity may increase. Accordingly, the first portion 112a disposed below the source electrode 123 and/or the drain electrode 124 may have a relatively thick thickness (e.g., a relatively large number of stacks) so as to reduce the contact resistance, and the second portion 112b disposed below the gate insulating film 121 may have a relatively thin thickness (e.g., a relatively small number of stacks). Therefore, the thickness of the first portion 112a may be greater than the thickness of the second portion 112b. In other words, the number of stacks of the transition metal dichalcogenide material of the first portion 112a may be greater than the number of stacks of the transition metal dichalcogenide material of the second portion 112b. For example, when both the first portion 112a and the second portion 112b include PtSe₂, the first portion 112a may include three or more layers of PtSe₂ and the second portion 112b may include two or fewer layers of PtSe₂.

A case where the inside of one second transition metal dichalcogenide layer 112 disposed on the first transition metal dichalcogenide layer 111 has a single composition has been described, but the composition may gradually change in one second transition metal dichalcogenide layer 112. FIG. 15 is a cross-sectional view schematically illustrating a structure of a semiconductor device according to at least one example embodiment. Referring to FIG. 15, a second transition metal dichalcogenide layer 112 of a channel layer 110e may include at least two different transition metal dichalcogenide materials. A ratio between different transition metal dichalcogenide materials in the second transition metal dichalcogenide layer 112 may gradually and continuously change along the thickness direction. In other words, the second transition metal dichalcogenide layer 112 may include two or more different transition metals or two or more different chalcogen elements, and a ratio between the two or more different transition metals or a ratio between the two or more different chalcogen elements may gradually and continuously change along the thickness direction of the second transition metal dichalcogenide layer 112.

For example, the second transition metal dichalcogenide layer 112 may include a first region 112A on the first transition metal dichalcogenide layer 111, a second region 112B on the first region 112A, and a third region 112C on the second region 112B. The first region 112A may include a first transition metal and a first chalcogen element. The third region 112C may include the first transition metal and a second chalcogen element that is different from the first chalcogen element. The second region 112B may include the first transition metal, the first chalcogen element, and the second chalcogen element. In the second region 112B, a proportion of the first chalcogen element may gradually and continuously decrease along the thickness direction from the first region 112A to the third region 112C, and a proportion of the second chalcogen element may gradually and continuously increase. Alternatively, the third region 112C may include a second transition metal that is different from the first transition metal, and the first chalcogen element. The second region 112B may include the first transition metal, the second transition metal, and the first chalcogen element. In the second region 112B, a proportion of the first transition metal may gradually and continuously decrease along the thickness direction from the first region 112A to the third region 112C, and a proportion of the second transition metal may gradually and continuously increase. The band gap of the channel layer 110e may be finely controlled to a desired value through the gradient distribution of the heterogeneous transition metals or the gradient distribution of the heterogeneous chalcogen elements. Accordingly, the threshold voltage of the semiconductor device may be controlled.

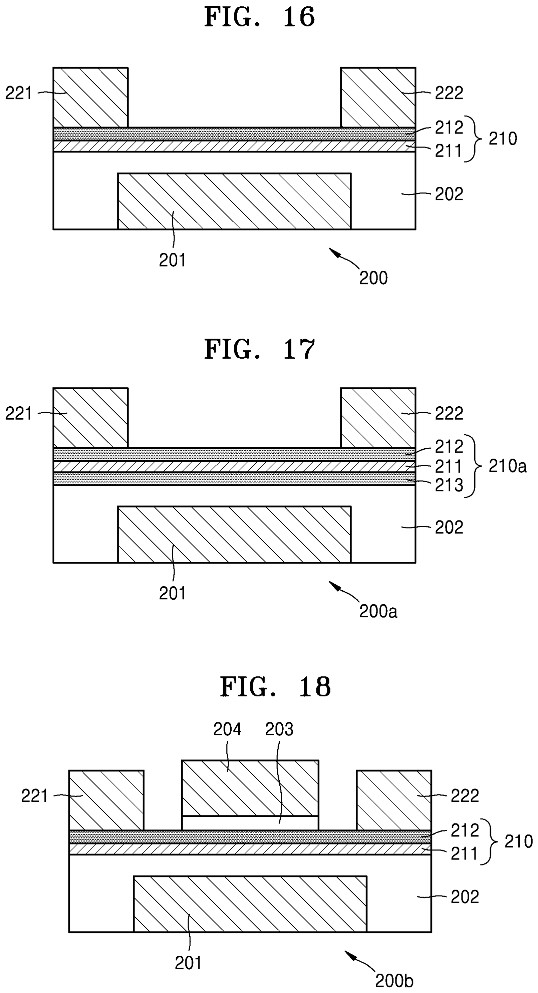

FIG. 16 is a cross-sectional view schematically illustrating a structure of a semiconductor device according to at least one example embodiment. The semiconductor devices described above are FETs having the top gate structure in which the gate electrode is disposed at the upper side, but the disclosure is not necessarily limited thereto. The semiconductor device may have a bottom gate structure in which the gate electrode is disposed at the lower side. Referring to FIG. 16, a semiconductor device 200 may include a gate electrode 201, a gate insulating film 202 surrounding both side surfaces and the upper surface of the gate electrode 201, a channel layer 210 on the upper surface of the gate insulating film 202, and a source electrode 221 and a drain electrode 222 electrically connected to the channel layer 210.

In the bottom gate structure, the source electrode 221 and the drain electrode 222 may be respectively disposed on an opposite side to the gate electrode 201 with respect to the channel layer 210. For example, the source electrode 221 and the drain electrode 222 may be disposed above the channel layer 210, and the gate electrode 201 may be disposed below the channel layer 210. The source electrode 221 and the drain electrode 222 may be spaced apart from each other on the upper surface of the channel layer 210. In other words, the channel layer 210 may include a first surface and a second surface facing each other, the source electrode 221 and the drain electrode 222 may be spaced apart from each other on the first surface of the channel layer 210, and the gate electrode 201 may be disposed to face the second surface of the channel layer 210.

The channel layer 210 may include a first transition metal dichalcogenide layer 211 on the gate insulating film 202 and a second transition metal dichalcogenide layer 212 on the first transition metal dichalcogenide layer 211. The first transition metal dichalcogenide layer 211 may be provided by directly growing on the gate insulating film 202, and the second transition metal dichalcogenide layer 212 may be provided by directly growing on the first transition metal dichalcogenide layer 211. The first transition metal dichalcogenide layer 211 may be the same as the first transition metal dichalcogenide layer 111 described with reference to FIG. 1, and the second transition metal dichalcogenide layer 212 may be the same as the second transition metal dichalcogenide layer 112 described with reference to FIG. 1.

FIG. 17 is a cross-sectional view schematically illustrating a structure of a semiconductor device according to at least one example embodiment. Referring to FIG. 17, a channel layer 210a of a semiconductor device 200a may further include a third transition metal dichalcogenide layer 213 disposed below a first transition metal dichalcogenide layer 211. The remaining elements of the semiconductor device 200a may be the same as those of the semiconductor device 200 illustrated in FIG. 16. The third transition metal dichalcogenide layer 213 may be disposed between a gate insulating film 202 and a first transition metal dichalcogenide layer 211. In other words, the third transition metal dichalcogenide layer 213 may be disposed on the gate insulating film 202, the first transition metal dichalcogenide layer 211 may be disposed on the third transition metal dichalcogenide layer 213, and a second transition metal dichalcogenide layer 212 may be disposed on the first transition metal dichalcogenide layer 211. The third transition metal dichalcogenide layer 213 may be the same as the third transition metal dichalcogenide layer 113 described with reference to FIG. 2.

FIG. 18 is a cross-sectional view schematically illustrating a structure of a semiconductor device according to at least one example embodiment. Referring to FIG. 18, a semiconductor device 200b may be an FET having a dual gate structure. Compared with the semiconductor device 200 illustrated in FIG. 16, the semiconductor device 200b illustrated in FIG. 18 may further include an upper gate insulating film 203 disposed between the source electrode 221 and the drain electrode 222 on the upper surface of the channel layer 210, and an upper gate electrode 204 disposed on the upper gate insulating film 203. In this case, the gate electrode 201 may be a "lower gate electrode" and the gate insulating film 202 may be a "lower gate insulating film."

A case where the semiconductor device is an FET having a planar channel has been described, but the disclosure is not necessarily limited thereto. For example, the technical aspect according to the embodiment described above may be applied to a FinFET, a gate-all-around FET (GAAFET), or a multi-bridge channel FET (MBCFET) having a three-dimensional channel structure.

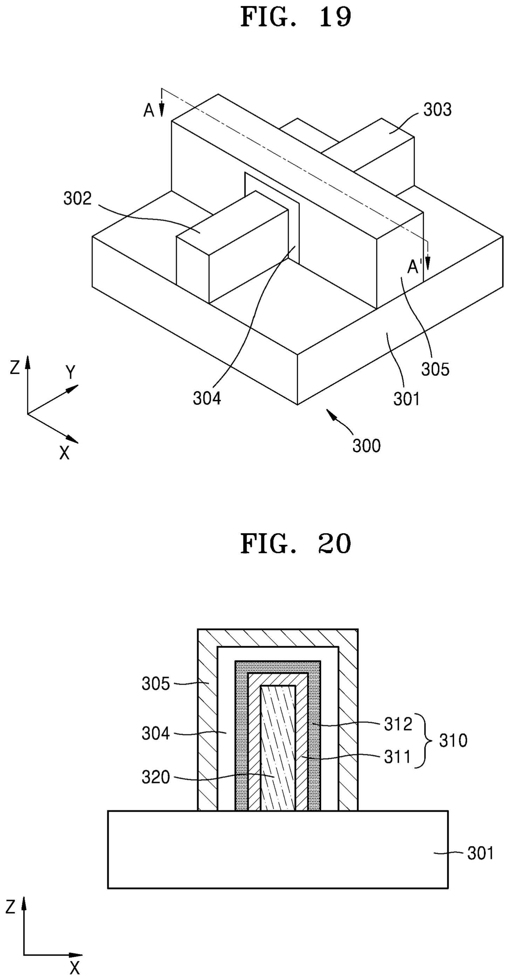

FIG. 19 is a perspective view schematically illustrating a structure of a semiconductor device 300 according to at least some example embodiments, and FIG. 20 is a cross-sectional view schematically illustrating a channel layer 310 and a gate electrode 305 of the semiconductor device 300 of FIG. 19 taken along line A-A' of FIG. 19. The semiconductor device 300 illustrated in FIGS. 19 and 20 may be a FinFET. Referring to FIGS. 19 and 20, the semiconductor device 300 may include a substrate 301 having an insulating property, the channel layer 310 protruding from the substrate 301 in a first direction (a Z-axis direction), a gate insulating film 304 surrounding both side surfaces of the channel layer 310 in a second direction (an X-axis direction) perpendicular to the first direction and the upper surface of the channel layer 310, the gate electrode 305 surrounding both side surfaces of the gate insulating film 304 in the second direction and the upper surface of the gate insulating film 304, a source electrode 302 protruding from the substrate 301 in the first direction and electrically connected to a first side surface of the channel layer 310 in a third direction (a Y-axis direction) perpendicular to the first and second directions, and a drain electrode 303 protruding from the substrate 301 in the first direction and electrically connected to a second side surface opposite to the first side surface of the channel layer 310 in the third direction.

The channel layer 310 may include a first transition metal dichalcogenide layer 311 and a second transition metal dichalcogenide layer 312. The second transition metal dichalcogenide layer 312 may surround both side surfaces of the first transition metal dichalcogenide layer 311 in the second direction and the upper surface of the first transition metal dichalcogenide layer 311. Otherwise, the first transition metal dichalcogenide layer 311 may be the same as (or substantially similar to) the first transition metal dichalcogenide layer 111 illustrated in FIG. 1, and the second transition metal dichalcogenide layer 312 may be the same as (or substantially similar to) the second transition metal dichalcogenide layer 112 illustrated in FIG. 1.

Although not illustrated, the channel layer 310 may further include a third transition metal dichalcogenide layer. In this case, the first transition metal dichalcogenide layer 311 may surround both side surfaces of the third transition metal dichalcogenide layer in the second direction and the upper surface of the third transition metal dichalcogenide layer. The third transition metal dichalcogenide layer may be the same as the third transition metal dichalcogenide layer 113 illustrated in FIG. 2.

In addition, the semiconductor device 300 may further include a support 320 that supports the channel layer 310. The support 320 may protrude from the substrate 301 in the first direction. The channel layer 310 may surround three sides of the support 320. For example, the first transition metal dichalcogenide layer 311 may surround both side surfaces of the support 320 in the second direction and the upper surface of the support 320. When the channel layer 310 includes the third transition metal dichalcogenide layer, the third transition metal dichalcogenide layer may surround both side surfaces of the support 320 in the second direction and the upper surface of the support 320.

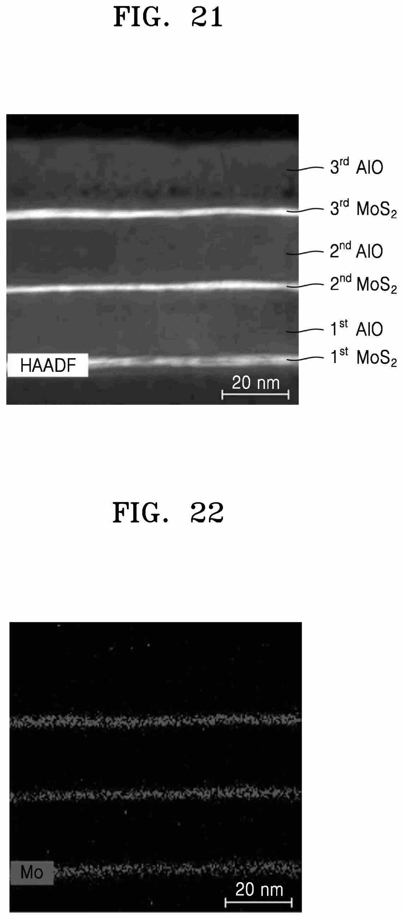

As described above, the gate insulating film and the gate electrodes may be directly grown with high quality on the nano-crystalline grain transition metal dichalcogenide material. Therefore, the channel layer and the gate structure may be stacked repeatedly vertically. In addition, there is no need to interpose a separate interlayer, such as a seed layer, between the channel layer and the gate structure. For example, FIG. 21 is a TEM image showing a stack structure in which aluminum oxides and MoS₂ layers are alternately grown. Referring to FIG. 21, a first MoS₂ layer, a first aluminum oxide layer, a second MoS₂ layer, a second aluminum oxide layer, a third MoS₂ layer, and a third aluminum oxide layer may be sequentially grown directly on an aluminum oxide substrate. The first MoS₂ layer, the first aluminum oxide layer, the second MoS₂ layer, the second aluminum oxide layer, the third MoS₂ layer, and the third aluminum oxide layer, which are grown as described above, may have relatively uniform thicknesses. Although not visible in the image of FIG. 21, the first MoS₂ layer, the second MoS₂ layer, and the third MoS₂ layer each include highly crystalline MoS₂ grown at a temperature of 600 °C and nano-crystalline grain MoS₂ grown at a temperature of 350 °C. For example, after highly crystalline MoS₂ is grown on an aluminum oxide layer at a temperature of 600 °C, nano-crystalline grain MoS₂ may be directly grown on the highly crystalline MoS₂ at a temperature of 350 °C, and then, an aluminum oxide layer may be directly grown on the nano-crystalline grain MoS₂.

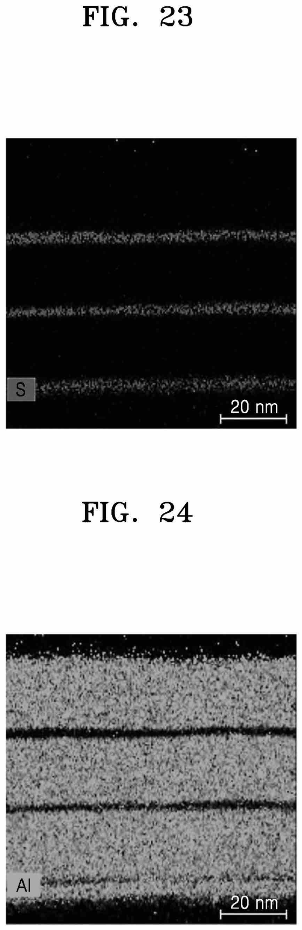

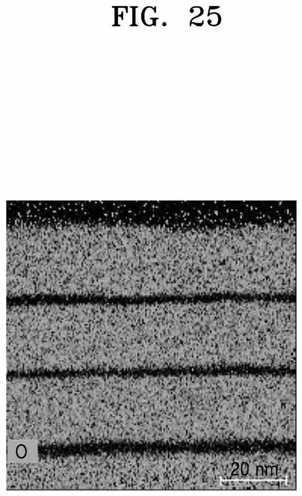

FIGS. 22 to 25 are element mapping images showing the element distributions of molybdenum (Mo), sulfur (S), aluminum (Al), and oxygen (O) in the stack structure illustrated in FIG. 21, respectively. Referring to FIGS. 22 and 23, it may be confirmed that other elements except for molybdenum (Mo) and sulfur (S) are hardly distributed in the first to third MoS₂ layers. Referring to FIGS. 24 and 25, it may be confirmed that other elements except for aluminum (Al) and oxygen (O) are hardly distributed in the first to third aluminum oxide layers. Therefore, it may be confirmed that, during the process of repeatedly and directly growing the MoS₂ layer and the aluminum oxide layer, the MoS₂ layer is not oxidized or contaminated with other elements and the aluminum oxide layer is not contaminated with other elements. In addition, it may be confirmed that almost no unintended interface layer is formed between the MoS₂ layer and the aluminum oxide layer.

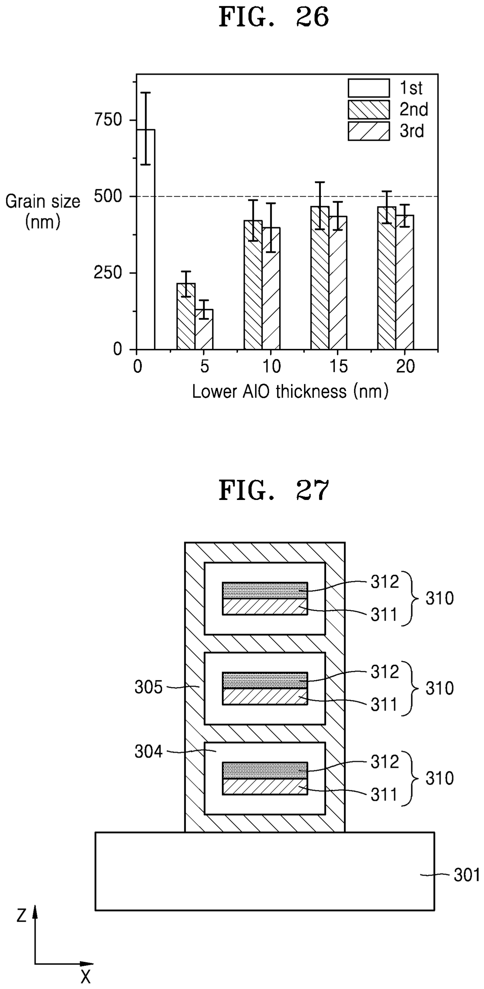

FIG. 26 is a graph showing the grain size of highly crystalline MoS₂ according to the thickness of the aluminum oxide layer. Referring to FIG. 26, when the thickness of the lower aluminum oxide layer is 5 nm or more, the deviation between the grain size of the highly-crystalline MoS₂ of the second MoS₂ layer and the grain size of the highly-crystalline MoS₂ of the third MoS₂ layer may be relatively small. In other words, even when the insulating film and the transition metal dichalcogenide layer are repeatedly stacked, the quality deviation between the layers may be small and the layers may be grown homogeneously. Therefore, a GAAFET or an MBCFET including a plurality of channel layers disposed in the thickness direction or the vertical direction may be manufactured with high quality.

FIG. 27 is a cross-sectional view schematically illustrating a channel layer and a gate electrode of a semiconductor device according to at least some example embodiments. A structure of a source electrode and a drain electrode in the semiconductor device illustrated in FIG. 27 may be the same as the structure of the source electrode 302 and the drain electrode 303 described with reference to FIG. 19. FIG. 27 illustrates a structure of a channel layer and a gate electrode in the cross-section in the same direction as in FIG. 20. Referring to FIG. 27, the semiconductor device may include a plurality of channel layers 310 disposed at intervals from a substrate 301 along the first direction (the Z-axis direction). Although FIG. 27 illustrates three channel layers 310 as an example, this is not limited and the semiconductor device may include more than three channel layers.

The semiconductor device may also include a plurality of gate insulating films 304 surrounding both side surfaces of each of the plurality of channel layers 310 in the second direction (the X-axis direction) and the lower and upper surfaces of each of the plurality of channel layers 310, and a gate electrode 305 surrounding both side surfaces of each of the plurality of gate insulating films 304 in the second direction and the lower and upper surfaces of the plurality of gate insulating films 304. In other words, each of the plurality of gate insulating films 304 may surround four sides of the corresponding channel layer among the plurality of channel layers 310. The gate electrode 305 may protrude from the substrate 301 in the first direction so as to surround four sides of each of the plurality of gate insulating films 304. The plurality of gate insulating films 304 may be disposed at intervals from the substrate 301 along the first direction, and the gate electrode 305 may be disposed between the plurality of gate insulating films 304.

The channel layer 310 may include a first transition metal dichalcogenide layer 311 and a second transition metal dichalcogenide layer 312. The second transition metal dichalcogenide layer 312 may be disposed on the first transition metal dichalcogenide layer 311 in the first direction. In other words, the second transition metal dichalcogenide layer 312 may be disposed on the upper surface of the first transition metal dichalcogenide layer 311. The lower surface and both side surfaces of the first transition metal dichalcogenide layer 311 and the both side surfaces and the upper surface of the second transition metal dichalcogenide layer 312 may be surrounded by the gate insulating film 304.

Although not illustrated, the channel layer 310 may further include a third transition metal dichalcogenide layer disposed below the first transition metal dichalcogenide layer 311. The first transition metal dichalcogenide layer 311 may be disposed between the third transition metal dichalcogenide layer and the second transition metal dichalcogenide layer 312. In this case, the lower surface and both side surfaces of the third transition metal dichalcogenide layer, both side surfaces of the first transition metal dichalcogenide layer 311, and both side surfaces and the upper surface of the second transition metal dichalcogenide layer 312 may be surrounded by the gate insulating film 304.

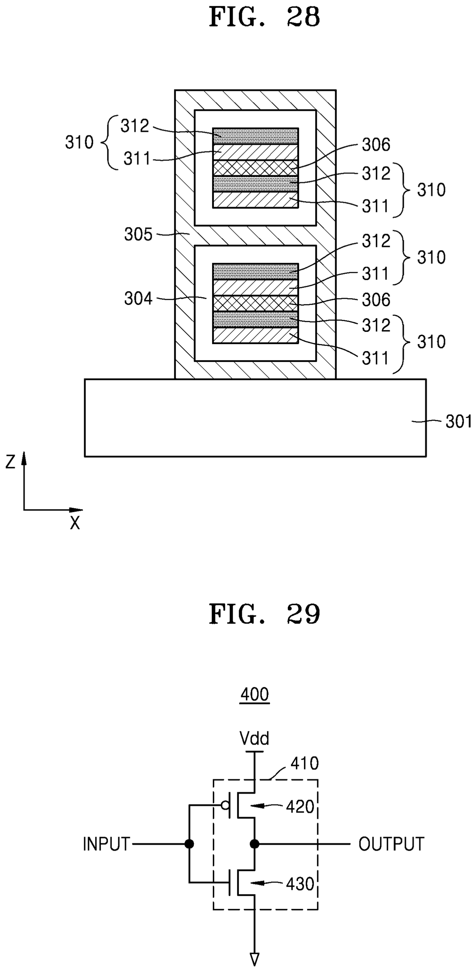

FIG. 28 is a cross-sectional view schematically illustrating a channel layer and a gate electrode of a semiconductor device according to at least some example embodiments. Referring to FIG. 28, two channel layers 310 may be surrounded by one gate insulating film 304. Accordingly, the number of channel layers 310 may be twice the number of gate insulating films 304. An insulator bridge 306 may be disposed between the two channel layers 310 surrounded by the one gate insulating film 304. Accordingly, a first transition metal dichalcogenide layer 311, a second transition metal dichalcogenide layer 312, an insulator bridge 306, a first transition metal dichalcogenide layer 311, and a second transition metal dichalcogenide layer 312 may be sequentially stacked in the one gate insulating film 304 along the first direction. In addition, when the channel layer 310 further includes a third transition metal dichalcogenide layer, the third transition metal dichalcogenide layer, the first transition metal dichalcogenide layer 311, the second transition metal dichalcogenide layer 312, the insulator bridge 306, the third transition metal dichalcogenide layer, the first transition metal dichalcogenide layer 311, and the second transition metal dichalcogenide layer 312 may be sequentially stacked in the one gate insulating film 304 along the first direction.

The semiconductor devices described above may be used in, for example, a driving integrated circuit of a display, a complementary metal-oxide semiconductor (CMOS) inverter, a CMOS static random access memory (SRAM) device, a CMOS NOT-AND (CMOS NAND) circuit, a CMOS dynamic random access memory (DRAM), and/or various other electronic devices.

FIG. 29 is a circuit diagram of a CMOS inverter 400 according to at least one example embodiment. Referring to FIG. 29, the CMOS inverter 400 includes a CMOS transistor 410. The CMOS transistor 410 includes a p-channel metal-oxide semiconductor (PMOS) transistor 420 and an n-channel metal-oxide semiconductor (NMOS) transistor 430 connected between a power terminal Vdd and a ground terminal. The CMOS transistor 410 may include the semiconductor devices according to the embodiments described above.

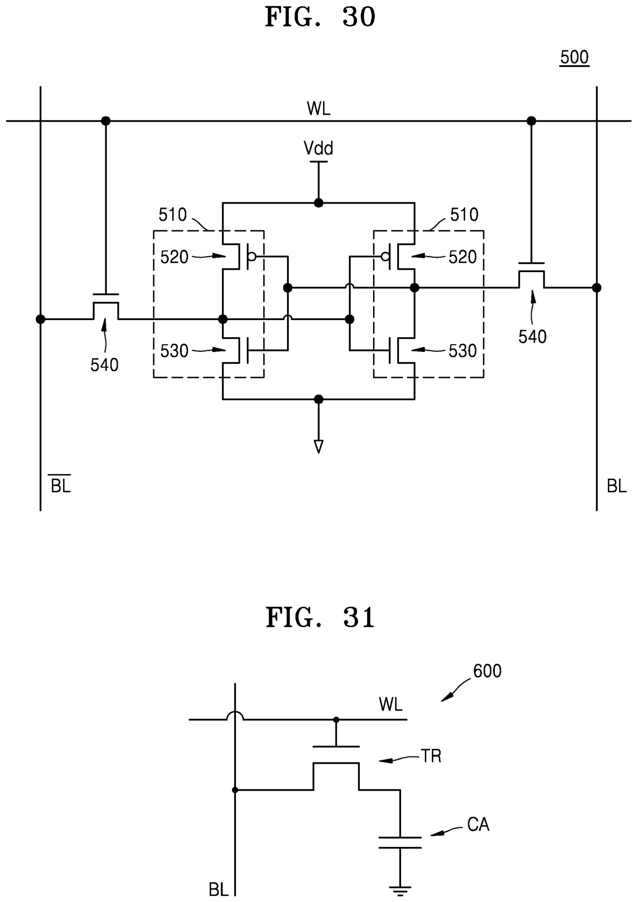

FIG. 30 is a circuit diagram of a CMOS SRAM device 500 according to at least one example embodiment. Referring to FIG. 30, the CMOS SRAM device 500 includes a pair of driving transistors 510. The pair of driving transistors 510 each includes a PMOS transistor 520 and an NMOS transistor 530 connected between a power terminal Vdd and a ground terminal. The CMOS SRAM device 500 may further include a pair of transmission transistors 540. A source of the transmission transistor 540 is cross-connected to a common node of the PMOS transistor 520 and the NMOS transistor 530 constituting the driving transistor 510. The power terminal Vdd is connected to a source of the PMOS transistor 520, and the ground terminal is connected to a source of the NMOS transistor 530. A word line WL may be connected to a gate of the pair of transmission transistors 540, and a bit line BL and an inverted bit line may be connected to a drain of each of the pair of transmission transistors 540, respectively. At least one of the driving transistor 510 and the transmission transistor 540 of the CMOS SRAM device 500 may include a semiconductor device according to the embodiments described above.

FIG. 31 is a circuit diagram of a CMOS DRAM device 600 according to at least one example embodiment. Referring to FIG. 31, the CMOS DRAM device 600 includes one transistor TR, one capacitor CA, a word line WL, and a bit line BL. The word line WL may be electrically connected to a gate of the transistor TR, and the bit line BL may be electrically connected to a source of the transistor TR. A first electrode of the capacitor CA may be connected to a drain of the transistor TR, and a second electrode of the capacitor CA may be grounded. The transistor TR of the CMOS DRAM device 600 may include a semiconductor device according to the embodiments described above.

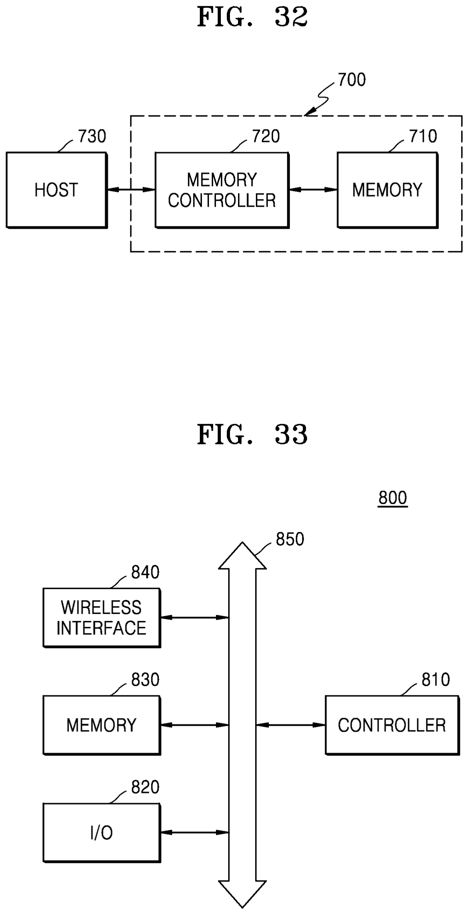

FIG. 32 is a block diagram illustrating an electronic apparatus 700 according to at least one example embodiment. Referring to FIG. 32, the electronic apparatus 700 includes a memory 710 and a memory controller 720. The memory controller 720 may control the memory 710 to read data from and/or write data into the memory 710 in response to a request from the host 730. At least one of the memory 710 or the memory controller 720 may include a semiconductor device according to the embodiments described in FIGS. 1 to 11.

FIG. 33 is a block diagram of an electronic apparatus 800 according to at least one example embodiment. Referring to FIG. 33, the electronic apparatus 800 may constitute a wireless communication device or a device capable of transmitting and/or receiving information in a wireless environment. The electronic apparatus 800 includes a controller 810, an input/output (I/O) device 820, a memory 830, and a wireless interface 840, and these components are interconnected to each other through a bus 850.

The controller 810 may include at least one of a microprocessor, a digital signal processor, and a processing device similar thereto. The I/O device 820 may include at least one of a keypad, a keyboard, and a display. The memory 830 may be used to store instructions executed by controller 810. For example, the memory 830 may be used to store user data. The electronic apparatus 800 may use the wireless interface 840 to transmit/receive data through a wireless communication network. The wireless interface 840 may include an antenna and/or a wireless transceiver. In some embodiments, the electronic apparatus 800 may be used in a communication interface protocol of a third-generation communication system, for example, code division multiple access (CDMA), global system for mobile communications (GSM), north American digital cellular (NADC), extended-time division multiple access (E-TDMA), and/or wide band code division multiple access (WCDMA).

The electronic apparatus 800 may include a semiconductor device according to the embodiments described above.

According to at least one example embodiment, the channel layer of the semiconductor device includes a highly crystalline transition metal dichalcogenide layer and a nano-crystalline grain transition metal dichalcogenide layer thereon. The nano-crystalline grain transition metal dichalcogenide layer may reduce or prevent the highly crystalline transition metal dichalcogenide layer from being peeled off from another layer therebelow when a chemical material, such as a developer, penetrates into the highly crystalline transition metal dichalcogenide layer during the process of manufacturing the semiconductor device.

In addition, the nano-crystalline grain transition metal dichalcogenide layer may reduce or prevent the highly crystalline transition metal dichalcogenide layer from being damaged, oxidized, or contaminated by exposure to heat, oxygen, or various other chemicals during the process of manufacturing the semiconductor device.

Furthermore, an insulator may be uniformly deposited on the nano-crystalline grain transition metal dichalcogenide layer. Therefore, the gate insulating film and the gate electrode may be deposited with high quality on the channel layer.

It should be understood that embodiments described herein should be considered in a descriptive sense only and not for purposes of limitation. Descriptions of features or aspects within each embodiment should typically be considered as available for other similar features or aspects in at least some example embodiments. While one or more embodiments have been described with reference to the figures, it will be understood by those of ordinary skill in the art that various changes in form and details may be made therein without departing from the scope as defined by the following claims.

## Claims

1. A semiconductor device comprising:
a channel layer comprising a first transition metal dichalcogenide layer and a second transition metal dichalcogenide layer on the first transition metal dichalcogenide layer;
a gate electrode facing the channel layer;
a gate insulating film between the channel layer and the gate electrode; and
a source electrode and a drain electrode electrically connected to the channel layer,
wherein the first transition metal dichalcogenide layer comprises a highly crystalline transition metal dichalcogenide material having a two-dimensional crystal structure, and the second transition metal dichalcogenide layer comprises a nano-crystalline grain transition metal dichalcogenide material having a two-dimensional crystal structure.

2. The semiconductor device of claim 1, wherein
a grain size of the second transition metal dichalcogenide layer is 10 nanometers, nm, or less, and
a grain size of the first transition metal dichalcogenide layer is 50 nm or more.

3. The semiconductor device of claim 1 or 2, wherein a distance between the first transition metal dichalcogenide layer and the second transition metal dichalcogenide layer is 2 nanometers, nm, or less.

4. The semiconductor device of one of claims 1 to 3, wherein
the first transition metal dichalcogenide layer comprises the highly crystalline transition metal dichalcogenide material having the two-dimensional crystal structure stacked in 1 to 10 layers, and
the second transition metal dichalcogenide layer comprises the nano-crystalline grain transition metal dichalcogenide material having the two-dimensional crystal structure stacked in 1 to 10 layers.

5. The semiconductor device of one of claims 1 to 4, wherein an atomic ratio of a chalcogen element to a transition metal in the second transition metal dichalcogenide layer is within ±20 % of an atomic ratio of a chalcogen element to a transition metal in the first transition metal dichalcogenide layer, or
wherein an atomic ratio of a chalcogen element to a transition metal in the first transition metal dichalcogenide layer and the second transition metal dichalcogenide layer is 1.7 or more, or
wherein a proportion of metals having an oxidation number of +4 among all metals in the first transition metal dichalcogenide layer is 80 % or more, and a proportion of metals having an oxidation number of +4 among all metals in the second transition metal dichalcogenide layer is 80 % or more.

6. The semiconductor device of one of claims 1 to 5, wherein the channel layer further comprises a third transition metal dichalcogenide layer disposed below the first transition metal dichalcogenide layer, the first transition metal dichalcogenide layer is disposed between the third transition metal dichalcogenide layer and the second transition metal dichalcogenide layer, and
the third transition metal dichalcogenide layer comprises a nano-crystalline grain transition metal dichalcogenide material having a two-dimensional crystal structure.

7. The semiconductor device of one of claims 1 to 6, wherein the first transition metal dichalcogenide layer and the second transition metal dichalcogenide layer comprise transition metal dichalcogenide materials having a same conductivity type, or
wherein the first transition metal dichalcogenide layer and the second transition metal dichalcogenide layer comprise at least one of a same transition metal or a same chalcogen element.

8. The semiconductor device of one of claims 1 to 7, wherein the second transition metal dichalcogenide layer comprises a first transition metal and a second transition metal, which are different from each other and a proportion of the first transition metal gradually increases and a proportion of the second transition metal gradually decreases along a thickness direction in the second transition metal dichalcogenide layer, or
the second transition metal dichalcogenide layer comprises a first chalcogen element and a second chalcogen element, which are different from each other, and a proportion of the first chalcogen element gradually increases and a proportion of the second chalcogen element gradually decreases along the thickness direction in the second transition metal dichalcogenide layer.

9. The semiconductor device of one of claims 1 to 8, further comprising:
a substrate,
wherein the channel layer is on the substrate,
the source electrode and the drain electrode are spaced apart from each other on the channel layer,
the gate insulating film is between the source electrode and the drain electrode on the channel layer, and
the gate electrode is on the gate insulating film.

10. The semiconductor device of claim 9, wherein
the second transition metal dichalcogenide layer comprises a first portion between the first transition metal dichalcogenide layer and the source electrode and between the first transition metal dichalcogenide layer and the drain electrode, and a second portion between the first transition metal dichalcogenide layer and the gate insulating film, and
a thickness of the first portion is greater than a thickness of the second portion.

11. The semiconductor device of claim 10, further comprising:
a spacer between the gate electrode and the source electrode and between the gate electrode and the drain electrode,
wherein the second transition metal dichalcogenide layer further comprises a third portion between the first transition metal dichalcogenide layer and the spacer, and
an absolute value of a difference in Fermi level between the first portion and the first transition metal dichalcogenide layer, an absolute value of a difference in Fermi level between the second portion and the first transition metal dichalcogenide layer, and an absolute value of a difference in Fermi level between the third portion and the first transition metal dichalcogenide layer are each greater than zero.

12. The semiconductor device of one of claims 1 to 11, further comprising:
a substrate, wherein the channel layer protrudes from the substrate in a first direction, the gate insulating film surrounds an upper surface of the channel layer and both side surfaces of the channel layer in a second direction perpendicular to the first direction, and the gate electrode surrounds an upper surface of the gate insulating film and both side surfaces of the gate insulating film in the second direction, or
a substrate, wherein the channel layer comprises a plurality of channel layers spaced apart at intervals from the substrate in a first direction, the gate insulating film comprises a plurality of gate insulating films surrounding lower and upper surfaces of each of the plurality of channel layers and both side surfaces of each of the plurality of channel layers in a second direction perpendicular to the first direction, and the gate electrode protrudes from the substrate in the first direction so as to surround the plurality of gate insulating films.

13. A method of manufacturing a semiconductor device, the method comprising:
forming a channel layer, the channel layer comprising a first transition metal dichalcogenide layer and a second transition metal dichalcogenide layer on the first transition metal dichalcogenide layer;
forming a source electrode and a drain electrode such that the source electrode and the drain electrode are both electrically connected to the channel layer; and
forming a gate insulating film and a gate electrode on the gate insulating film such that the gate insulating film insulates the channel layer from the gate electrode,
wherein the first transition metal dichalcogenide layer comprises a highly crystalline transition metal dichalcogenide material having a two-dimensional crystal structure, and the second transition metal dichalcogenide layer comprises a nano-crystalline grain transition metal dichalcogenide material having a two-dimensional crystal structure.

14. The method of claim 13, wherein the forming of the channel layer comprises:
depositing the highly crystalline transition metal dichalcogenide material at a first temperature; and
depositing the nano-crystalline grain transition metal dichalcogenide material at a second temperature that is lower than the first temperature.

15. An electronic apparatus comprising:
a transistor comprising a channel layer, a gate electrode facing the channel layer, a gate insulating film between the channel layer and the gate electrode; and a source electrode and a drain electrode electrically connected to the channel layer, wherein the transistor is a semiconductor device according to one of claims 1 to 12;
a word line electrically connected to the gate electrode of the transistor;
a bit line electrically connected to the source electrode of the transistor; and
a capacitor electrically connected to the drain electrode of the transistor,
wherein the channel layer comprises a first transition metal dichalcogenide layer and a second transition metal dichalcogenide layer on the first transition metal dichalcogenide layer,
the first transition metal dichalcogenide layer comprises a highly crystalline transition metal dichalcogenide material having a two-dimensional crystal structure, and
the second transition metal dichalcogenide layer comprises a nano-crystalline grain transition metal dichalcogenide material having a two-dimensional crystal structure.
